# EUROPEAN PATENT APPLICATION

(11) **EP 3 343 780 A1**
(43) Date of publication of application: **04.07.2018**
(21) Application number: 17150055.6
(22) Date of filing: 02.01.2017
(51) Int. Cl.: H03M 1/78, H03K 19/0175

(54) **DIGITAL TO ANALOGUE CONVERSION COUPLING**

(71) Applicant: Verisure Sàrl, 1290 Versoix (CH)
(72) Inventor: Book, Johannes, 23131 Trelleborg (SE)
(74) Representative: Lindahl, Dan Emil

(57) **Abstract**

A digital to analogue conversion coupling where a microcontroller with software configurable ports is connected to a resistance network and wherein a first number of output ports of the microcontroller is connected to a resistance network comprising a second number of resistors, and wherein the first number of output ports include at least one general purpose port that is software configurable, and wherein different analogue output values can be achieved by altering the port configuration(s) among at least three different port configurations.

## Description

### TECHNICAL FIELD

The present invention relates to the field of electronics. More particularly it relates to the field of generating an analogue voltage output from a principally digital circuit, such as a microcontroller.

### PRIOR ART

The use of Digital to Analog Converters (DACs) is common in electronics today. These are often built in to microcontroller units (MCUs), for general use. The actual use of DACs may span from dynamically controlling the light output from an indicator Light Emitting Diode (LED), to producing sound, to setting the trigger level of some kind of detector or sensor - the DAC is a very general electronics building-block. General information about DACs can be found e.g. on Internet site https://en.wikipedia.org/wiki/Digital-to-analog converter.

### SUMMARY OF THE INVENTION

The objective of the present invention is to provide a simple and low cost solution to the problem of how to generate an analogue voltage from a microcontroller circuit, wherein the microcontroller circuit is not equipped with as many analogue outputs as needed, and/or wherein the number of output pins of the microcontroller circuit makes it difficult or impossible to generate an analogue voltage.

A specific problem may be to provide an analog signal to fine tune a trigger level of an external filter.

A known solution to the problem is to use an MCU that incorporates an internal DAC. However, in most, or in all common MCUs of today this internal DAC is tied to a few specific output pins on the MCU. These pins share functionality with other functional blocks, (also a very common feature of modern MCUs), and since those functional blocks already may be used for other purposes for the overall function of the device wherein the MCU is arranged, a built-in DAC may be a less favorable choice.

Another known solution may be to use a larger MCU with more available pins, but this may be a disadvantage from a cost perspective. Still another option may be to use an external DAC integrated circuit (IC), but again, this may drive costs upwards.

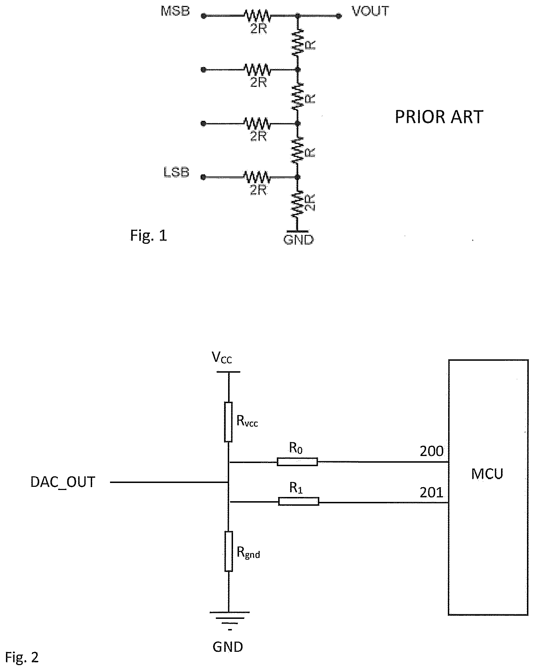

Another solution may be to use an external, discrete solution. Such a solution may include a resistor ladder of known configuration like the so-called R-2R ladder shown in Fig. 1. The R-2R ladder incorporates that a digital value, represented by a number of bits, here denoted as follows, a Most Significant Bit, MSB, a Least Significant Bit, LSB, and maybe additional intermediate significant bits, are converted by the resistance ladder to an analogue value. For each bit a "1" is represented by a first voltage and a "0" by a second voltage, wherein the first voltage is greater than the second voltage. A disadvantage with such a solution is that it implies a parallel representation, thus occupying as many pins of the MCU as the number of bits.

All the above-mentioned solutions have advantages as well as disadvantages, and the disadvantages may become very apparent depending on the particular application or development project. In particular, cost challenges and space challenges may prompt for another solution.

The inventive idea of the present invention is an innovative implementation of a DAC. The present invention comprises an inventive use of software configurable ports of a MCU connected to a particularly arranged resistor network in order to generate an analogue voltage.

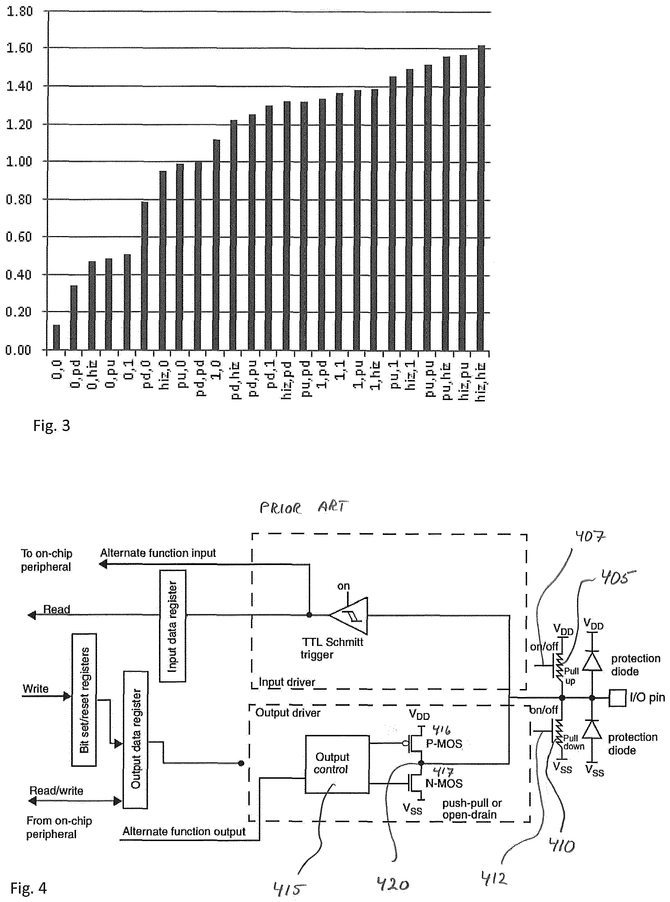

For example, using only four resistors and two MCU pins, 25 different output voltage levels are made available. Generally, Input-Outputs (IOs) pins on a modern MCU are - as mentioned above - shared between different functionality. It can be a DAC, some digital standardized interface, Analogue to Digital Converters (ADCs) or just general digital IOs. Such shared functionality pins are usually referred to as GPIOs - (GPIO = General Purpose Input-Output). These GPIO ports usually have several settings apart from the obvious HIGH and LOW outputs. The internal circuit diagram of such a MCU GPIO is shown in Fig. 4. The modes/configurations HIGH and LOW respectively are internally set by the output control unit 415 activating transistor 416 and deactivating transistor 417, or vice versa. Since a GPIO is also capable of being an input, it can be set in a high-impedance mode, usually to enable listening to an incoming signal being HIGH or LOW. Internally, such high impedance mode hiZ is internally set by deactivating pull-up resistor 405 via control gate 407, and also deactivating pulldown resistor 410 via control gate 412. Furthermore, to simplify external circuitry, they sometimes have built-in pull resistors. These are weak resistors; "pull-up" or "pull-down" of high resistance, typically between 10 kohm and 100 kohm. Pull resistors are commonly used for instance to keep a signal defined, high or low, when connected to a mechanical button - or to keep the signal defined when several different IC's can drive it. A common example is a reset signal, which is usually shared throughout many ICs in a design. More information on pull up resistors may be found at: https://en.wikipedia.org/wiki/Pull-up_resistor.

The inventive idea of the present invention is to connect a number of GPIOs to a resistance network, and to use the GPIOs over their full variability to create as many different analogue values as possible on an output terminal of the resistance network.

Thus, according to a first aspect there is provided a digital to analogue conversion coupling including a microcontroller having ports, wherein at least one of the ports is software configurable, and wherein a number of ports of the microcontroller are connected to a resistance network comprising a number of resistors, and wherein the number of ports include at least one port that is software configurable, and wherein different analogue output values are achieved by altering the software configurable port configuration(s) among at least two or three alternate configurations.

### BRIEF DESCRIPTION OF THE DRAWINGS

In order that the manner in which the above recited and other advantages and objects of the invention are obtained will be readily understood, a more particular description of the invention briefly described above will be rendered by reference to specific embodiments thereof which are illustrated in the appended drawings.

Understanding that these drawings depict only typical embodiments of the invention and are not therefore to be considered to be limiting of its scope, the invention will be described and explained with additional specificity and detail through the use of the accompanying drawings in which:
- Fig. 1: shows a wiring diagram of a prior art resistor ladder of type R-2R for digital to analogue conversion of a digital four-bit digital value.
- Fig. 2: shows a circuit diagram of a digital-to-analogue conversion circuit including a microcontroller for generating 25 different voltage levels using only two pins of an eight-pin microcontroller.
- Fig. 3: shows a diagram of discrete voltage values that may be obtained by a circuit with the principal configuration shown in Fig. 2.
- Fig. 4: shows a prior art internal wiring diagram of a GPIO of a microcontroller integrated circuit.
- Fig. 5: shows a diagram of discrete voltage values that may be obtained by an example circuit with the principal configuration shown in Fig. 2, and with particular resistance values.

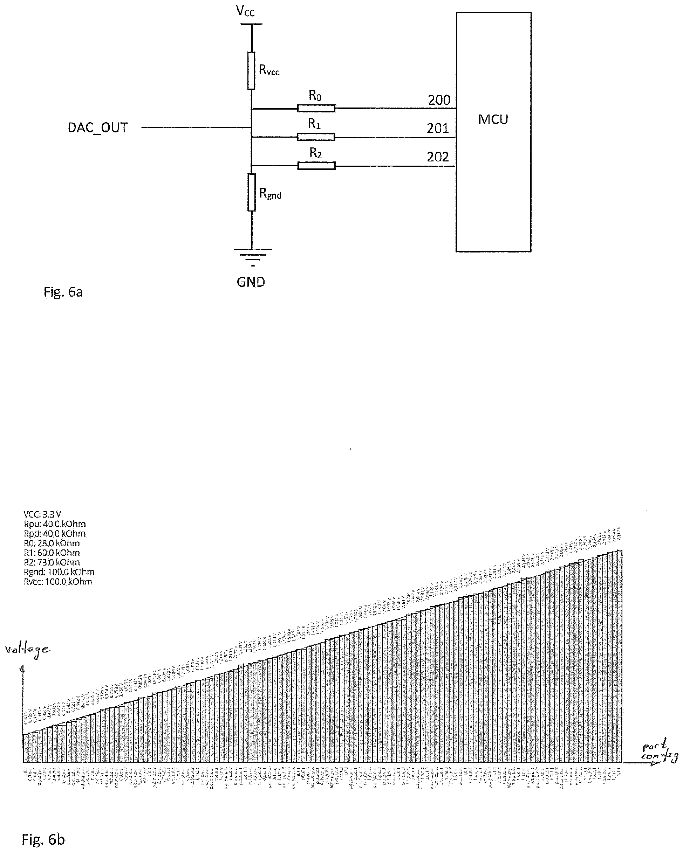

- Fig. 6a: shows a circuit diagram of a digital-to-analogue conversion circuit including a microcontroller for generating 125 different voltage levels using only three pins of an eight-pin microcontroller.
- Fig. 6b: shows a diagram of discrete voltage values that may be obtained by an example circuit with the configuration shown in Fig. 6a, and with particular resistance values.

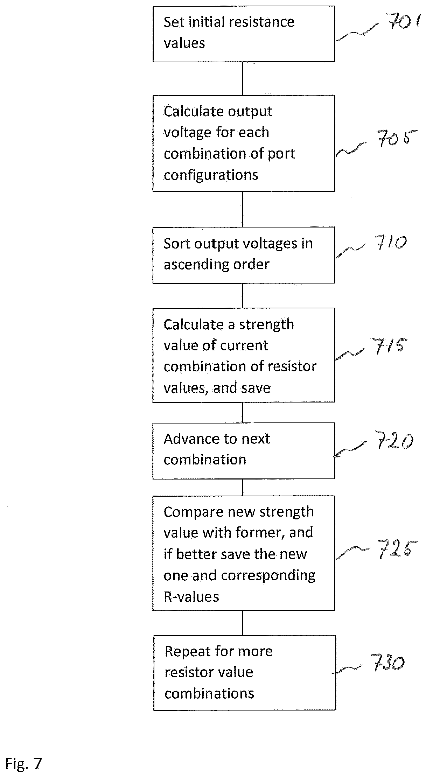

- Fig. 7: shows a flow chart of a method for determining resistance values of resistors of a resistor network of a digital to analogue conversion coupling.

### DETAILED DESCRIPTION

Fig. 1 shows a wiring diagram of a prior art resistor ladder of type R-2R for digital to analogue conversion of a digital four-bit digital value. A most significant bit is represented by letters "MSB" and a least significant bit is represented by letters "LSB" as conventionally done. Each bit can only assume one of two values at a particular moment in time, i.e., it can be a "1", usually represented by a voltage close to supply voltage; "HIGH", or it can be a "0" usually represented by a voltage close to ground; "LOW". With the coupling of Fig. 1 a number of different analogue voltages can be provided. The number of different voltages achievable with four bits are two to the power of number of bits, i.e., 16 (2*2*2*2).

The objective of the present invention is to provide a simple and low cost solution to the problem of how to generate an analogue voltage from a microcontroller circuit, wherein the microcontroller circuit is not equipped with as many analogue outputs as needed, and/or wherein the number of output pins of the microcontroller circuit makes it difficult or impossible to generate an analogue voltage using the prior art method and device of Fig. 1.

The present invention provides a circuit coupling that advantageously can provide 25 voltage levels using only two ports of an MCU or providing 125 voltage levels using only three ports of an MCU. In the general case 5 to the power of m voltage levels can be provided, where m is the number of ports to be used. For example, in a very accurate application some one million different output voltages may be needed. A classic DAC would need in the order of 21 bits. The same resolution using a circuit coupling according to the invention would require only 9 ports, and with 10 there would be a margin to compensate for possible less good linearity.

Fig. 2 shows a microcontroller in a digital to analogue conversion circuit diagram in an embodiment of the invention, for generating 25 different voltage levels using only two pins of a microcontroller. The microcontroller may be an AVR series from Atmel Corporation, MSP430 series from Texas Instruments, an EFM32 series from Silicon labs, or similar.

The digital to analogue conversion coupling includes a microcontroller with at least two software configurable ports. The two software configurable ports of the microcontroller are connected to a resistance network, external to the microcontroller. The network comprises four resistors. The digital to analogue conversion circuit including the microcontroller integrated circuit is configured to allow different analogue output values to be achieved by altering the software configurable port configurations among the following alternate configurations: output HIGH, output LOW, input non-pull, input pull-up, input pull-down. The input non-pull may in this context also or alternately be denoted "high impedance".

The resistor network comprises four resistors, i.e., a first resistor R0 connected between a first GPIO port 200 and a DAC output terminal DAC_OUT, a second resistor R1 connected between a second GPIO port 201 and the DAC output terminal DAC_OUT, a third resistor R_{GND} connected between ground GND and the DAC output terminal DAC_OUT, and a fourth resistor Rvcc connected between a supply voltage Vcc and the DAC output terminal DAC_OUT.

**Table 1: The lowest voltages are achieved by the following combinations of pin configurations:**

| Pin 1 | Pin 2 | Output (Relative) |
|---|---|---|
| 0 | 0 | 0,14 |
| 0 | pull-down | 0,33 |
| 0 | non-pull | 0,46 |
| 0 | pull-up | 0,47 |
| 0 | 1 | 0,51 |
| ... | | |

Fig. 3 shows a diagram of a complete list of discrete voltage values obtainable by the circuit of Fig. 2, and with certain values of the resistors in the network. By adjusting the values of the individual resistors in the network, i.e., the resistor Rvcc, connected between supply voltage and output terminal DAC_OUT, the resistor R₀, connected between MCU port 200 and output terminal DAC_OUT, the resistor R1 connected between MCU port 201 and output terminal DAC_OUT, and the resistor R_{gnd} connected between ground GND and output terminal DAC_OUT, linearity and voltage span may be varied.

In the conversion coupling according to figure 2, the resistance network is a discrete resistance network. In alternate embodiments, the resistance network may be an integrated circuit (IC) resistance network.

In the diagram of Fig. 2 the resistance network is a star four-resistor network comprising a first, a second, a third, and a forth resistor, wherein the analogue output is in the centre connection point and the first resistor is connected between centre connection point and VCC, the second resistor between centre connection point and first port, the third resistor between centre connection point and second port, and the fourth resistor between centre connection point and electrical ground.

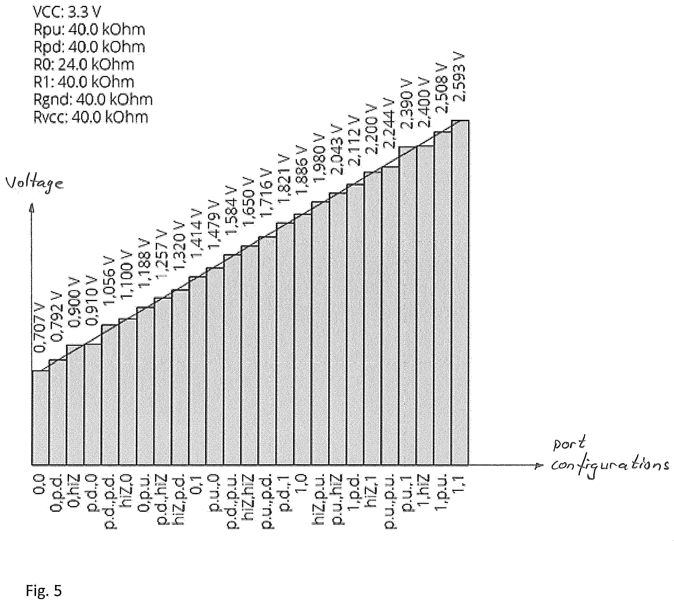

Fig. 5 shows a diagram of discrete voltage values that may be obtained by an example circuit with the principal configuration shown in Fig. 2, and with particular resistance values. This example circuit comprises resistors for the microcontroller GPIOs at values ranging from 24 to 40 kohm, wherein supply voltage is 3,3 Volt, MCU internal pull-up resistor is 40 kohm, MCU internal pull-down resistor is 40 kohm, R0 is 24 kohm, R1 is 40 kohm, and so are resistors to ground and to Vcc.

### Method

To generate an analogue voltage the microcontroller may preferably be programmed to include a table on how to set each GPIO to achieve a desired voltage, assuming a particular resistance network being connected to the GPIO pins concerned. An example of the beginning of such a table for a two GPIO port digital to analogue converter coupling is given above. To achieve a desired voltage, the voltage nearest the desired voltage is identified in the table, and the ports are configured as stated in the table.

### General configuration

The resistor network is in the general case configured as star, multiple-resistor network comprising a total of 2+n resistors, i.e., two plus n resistors wherein n is the number of GPIO pins desired to be used for the digital-to-analogue conversion. The analogue output will be in the centre connection point. There is one resistor Rvcc connected between centre connection point and the supply voltage Vcc. There is one resistor R_{GND} connected between electrical ground and the centre connection point. There is n+1 resistors named R0, R1,...Rn, one of which is associated to each GPIO port 200, 201,...20n. Each of these resistors R0, R1, R2 are connected between the respective GPIO and the centre connection point.

### Examples

In a first example, the inventor has demonstrated that a digital-to-analogue conversion from a common MCU having possibility to software configure two GPIOs as pull-up and pull-down ports with pull-down resistor value being equal to pull-up resistor value being equal 40 kohm, and wherein R0 has been chosen to be 24,0 kohm and R1 has been chosen to be 40,0 kohm, shows very good dynamics and linearity, see Fig. 2 and Fig. 5.

In a second example, the inventor has demonstrated that a digital-to-analogue conversion from a common MUC having possibility to software configure three GPIOs as pull-up and pull-down ports with pull-down resistor value being equal to pull-up resistor value being equal 40 kohm, and wherein R0 has been chosen to be 28,0 kohm and R1 has been chosen to be 60,0 kohm, and wherein R2 has been chosen to be 73 kohm, shows very good dynamics and linearity, see Fig. 2 and Fig. 5.

Some applications may prefer a lower output impedance, and to lower output impedance an external operational amplifier may be connected to the output, configured as a voltage follower. This may be applicable to the circuits of both the first and the second example.

### Determining the values of the individual resistors in the resistor network

The inventor has realised that other resistor values may be chosen. To determine the resistor values most suitable for an application the following computer implemented analysis method can be used, comprising the following steps:
- Set (701) resistance values of resistors R_{vcc}, R_{gnd}, R0, R1, ... Rn to initial values;
- Calculate (705) output voltages of circuit for each combination of configurations of the connected MCU GPIO ports 200, 201...20n
- Sort (710) output voltages in ascending order
- Calculate (715) a strength value for the current combination of resistor values, taking into account the linearity, and dynamics of the output voltages, and the output impedance of the circuit, and weighing them depending on the desired application;
- Save (715) strength value and corresponding resistor values;
- Advance (720) to next values combination of resistor values;
- Compare (725) new strength value with former one and if better save new strength and resistor values;
- Repeat (730) until a suitable condition is fulfilled or all combinations of resistor values of a suitable E-series have been visited.
The step of advance to next values combination of resistor values may comprise to
- Increase the first resistor value by one step
- Continue to step the resistor value (up or down) until the score no longer increases
- Repeat for all resistors, over and over again, until the best strength value no longer increases

**Legend**

| | |
|---|---|
| DAC_OUT | Digital-to-analogue output |
| GND | Ground |
| hiZ | port configured as high impedance |
| MCU | Microcontroller unit |
| pd | port configured as pull-down resistor |
| pu | port configured as pull-up resistor |
| R0 | Resistor R0 |
| R1 | Resistor R1 |
| R2 | Resistor R2 |
| R_{GND} | Resistor connected to ground |
| R_{VCC} | Resistor connected to supply voltage |
| V_{CC} | Supply voltage |

## Claims

1. A digital to analogue conversion coupling including a microcontroller (MCU) with at least one software configurable port (200)
**characterized in that**
a first number of ports (200, 201) of the microcontroller (MCU) are connected to a resistance network (R0, R1) comprising a second number of resistors, and wherein the first number of ports include at least one port that is software configurable, and wherein different analogue output values are achieved by altering the software configurable port configuration(s) among at least three alternate port configurations.

2. The conversion coupling according to claim 1, wherein the possible software configurable port configuration(s) includes the following configurations: port HIGH configuration (1), port LOW configuration (0), port with high impedance configuration (hiZ).

3. The conversion coupling according to claim 1, wherein the possible software configurable port configuration(s) includes the following configurations: port HIGH configuration (1), port LOW configuration (0), port with internal pull-down resistor configuration (pd), port with high impedance configuration (hiZ).

4. The conversion coupling according to claim 1, wherein the possible software configurable port configuration(s) includes the following configurations: port HIGH configuration (1), port LOW configuration (0), port with internal pull-up resistor configuration (pu), port with internal pull-down resistor configuration (pd), port with high impedance configuration (hiZ).

5. The conversion coupling according to any of claims 1 to 4, wherein the resistance network is a discrete resistance network.

6. The conversion coupling according to any of claims 1 to 4, wherein the resistance network is an integrated circuit (IC) resistance network.

7. The conversion coupling according to any of claims 1 to 6, wherein the first number of ports are two and are software configurable.

8. The conversion coupling according to claim 7 dependent on claim 4, wherein both ports are software configurable into one of the following configurations: port HIGH, port LOW, port with high impedance, port with pull-down, port with pull-up, and wherein the resistance network is a star four-resistor network comprising a first, a second, a third, and a forth resistor, wherein the analogue output is in the centre connection point and the first resistor is connected between centre connection point and Vcc, the second resistor between centre connection point and first port, the third resistor between centre connection point and second port, and the fourth resistor between centre connection point and electrical ground (GND).

9. The conversion coupling according to any of claims 1 to 6, wherein the first number of ports are three or more and the three ports all are software configurable.

10. The conversion coupling according to claim 9, wherein the three or more ports are software configurable into one of the following configurations: port HIGH, port LOW, port-High impedance, port with pull-down, port with pull-up, and wherein the resistance network is a star four-resistor network configuration comprising a first, a second, a third, a forth resistor, and a fifth resistor, wherein the analogue output is in the centre connection point and the first resistor is connected between centre connection point and Vcc, the second resistor between centre connection point and first port, the third resistor between centre connection point and second port, the fourth resistor between centre connection point and the third port, and the fifth resistor between centre connection point and electrical ground.

11. A method for determining resistor values in a digital to analogue
conversion coupling including a microcontroller (MCU) with at least one software configurable port (200) wherein
a first number of ports (200, 201) of the microcontroller (MCU) are connected to a resistance network (R0, R1) comprising a second number of resistors, and wherein the first number of ports include at least one port that is software configurable, and wherein different analogue output values are achieved by altering the software configurable port configuration(s) among at least three alternate port configurations, the method comprising the following steps:
- Set (701) resistance values of resistors R_{vcc}, R_{gnd}, R0, R1, ... Rn to initial values;
- Calculate (705) output voltages of circuit for each combination of configurations of the connected MCU GPIO ports 200, 201...20n
- Sort (710) output voltages in ascending order
- Calculate (715) a strength value for the current combination of resistor values, taking into account the linearity, and dynamics of the output voltages, and the output impedance of the circuit, and weighing them depending on the desired application;
- Save (715) strength value and corresponding resistor values;
- Advance (720) to next values combination of resistor values;
- Compare (725) new strength value with former one and if better save new strength and resistor values;
- Repeat (730) until a suitable condition is fulfilled or all combinations of resistor values of a suitable E-series have been visited.
